# NEW EUROPEAN PATENT SPECIFICATION

(11) **EP 0 536 607 B2**
(45) Date of publication and mention of the opposition decision: **30.05.2007**
(45) Mention of the grant of the patent: 13.11.1996
(21) Application number: 92116446.3
(22) Date of filing: 25.09.1992
(51) Int. Cl.: C03C 17/36, C03C 17/34

(54) **Heat processable metallic appearing coatings**
Metallisch aussehende, für Wärmebehandlung geeignete Beschichtungen
Revêtements d'aspects métalliques propres au traitement thermique

(30) Priority: 30.09.1991 US 768791; 29.11.1991 US 799806
(43) Date of publication of application: 14.04.1993
(73) Proprietor: PPG Industries Ohio, Inc., Cleveland, OH 44111 (US)
(72) Inventor: Gillery, Frank Howard, Allison Park, Pennsylvania 15101 (US); Waynar, Thomas Joseph, New Kensington, Pennsylvania 15068 (US); Finley, James Joseph, Pittsburgh, Pennsylvania 15238 (US); Arbab, Mehran, Pittsburgh, Pennsylvania 15217 (US)
(74) Representative: polypatent

(56) References cited:
- EP-A- 0 226 993
- EP-A- 0 233 003
- EP-A- 0 239 280
- EP-A- 0 281 894
- EP-A- 0 301 755
- EP-A- 0 530 676
- EP-A- 0 545 302
- WO-A-90/09883
- BE-A- 550 365
- JP-A- 63 242 948
- US-A- 4 900 630
- US-A- 4 992 087
- US-AU- 768 791
- CHEMICAL ABSTRACTS, vol. 111, no. 2, 10 July 1989, Columbus, Ohio, US; abstract no. 11542q, page 271 ;
- CHEMICAL ABSTRACTS, vol. 114, no. 18, 6 May 1991, Columbus, Ohio, US; abstract no. 169829k, page 346 ;
- E. Randich and D.D. Allread, Thin Solid Films 83 (1981) p.393-398
- C.G.Ribing and E.Valkonen, SPIE vol. 652(1986)
- B.Karlsson et al., Solar Energy Materials 7 (1983) p. 401-411

## Description

This invention relates generally to the art of vacuum coating, and more particularly to the art of producing vacuum coatings which maintain a metallic appearance and other metallic; throughout high temperature processes such as bending, laminating, and tempering.

Most vacuum coatings on glass which have a desirable metallic appearance and other metallic properties as deposited lose their characteristic metallic appearance and properties when subjected to high temperature processing. Vacuum coatings with a metallic appearance and other metallic properties, such as conductivity and infrared reflectance, are generally metals, metal nitrides, metal carbides or metal borides which oxidize when heated in air to form metal modes which are electrically insulating, more transparent and less absorbing. While many metals can be heated in air to the forming temperature of glass (600 to 700°C) developing a protective oxide surface layer, the thinness of transparent metallic coatings and their consequent non-bulk even porous, nature prevent the formation of a suitable protective layer. Thus thin transparent metallic appearing films generally cannot be heated to temperatures at which glass can be bent without degradation of metallic properties.

US-A-4,992,087 to Holscher discloses a process for the production of a tempered or bent glass plate with a transmission-reducing coating in which to one side of the glass plate is, applied at least one opaque metal coating predominantly at least one metal or alloy of elements 22 to 28, and a metal-containing protective coating of an alloy of aluminum and at least 10 atomic percent titanium and/or zirconium and thickness selected such that during tempering or bending there is no significant oxygen diffusion to the metal coating.

A titanium nitride coating has metallic properties that make it suitable for a durable solar control coating. By changing the coating thickness, the transmission and solar properties can be varied, and by adding the appropriate combination of dielectric layers, reflectance and color can be varied while maintaining chemical and mechanical durability.

Such coated articles have particular application in monolithic automotive glazing. When the coating is deposited on a dark substrate such as Solargray^{®} glass it can be used for privacy glazing with enhanced solar properties and a desired reflectance and color. On clear glass the titanium nitride layer can be adjusted to allow for greater than 70 percent transmittance of Illuminant A (LTA) with low internal reflectance, neutral appearance and enhanced solar properties. However most vehicle transparencies are bent and tempered.

JP-A-63,242,948 discloses a solar reflecting glass having low visible reflectance on the coated side, while the visible transmittance can be adjusted arbitrarily to a predetermined value. The glass comprises a metal layer (preferably Cr, Ti, Zr, Hf, Ta, Ni, Mo, Nb, W, Si, their alloys or stainless steel), a metal nitride layer (nitride or a composite nitride of Ti, Zr, Ta, Hf, and Cr) and a metal oxide layer (oxide or a composite oxide of Ti, Cr, Zr, Si, Al, Hf, Ta, and Nb). The problem that most vacuum coatings on glass which have desirable metallic appearance and other metallic properties as deposited lose their characteristic metallic appearance and properties when subjected to high temperature processing, is not addressed to in JP-A-63,242,948.

EP-A-0 239 280 describes a transparent glass sheet comprising thereon TiN, VN, NbN, TaN, CrN or Cr₃N₄ as the principal solar screening layer for reducing transmission of near infrared and thereover, a layer of tin oxide. The tin oxide layer serves to protect the metal nitride from oxidation during high-temperature processing procedures, increases the abrasion-resistance, and is useful in reducing the color and visible reflectivity properties of some metal nitride films.

It is the object of the present invention to provide a new metallic appearing coated article which maintains metallic appearance and other metallic properties throughout high-temperature processing, such as bending, laminating and tempering.

EP-A-546 302 is a prior art document pursuant to Art. 54(3) EPC that relates to a heat treated coated glass comprising a glass substrate, a solar control layer or an electroconductive layer on the glass substrate, and a first protective layer. The solar control layer may comprise at least one of stainless steel, titanium, chromium, zirconium, tantalum and hafnium, a nitride, a boride, a carbide of these metals, or a mixture of these. The protective layer may be inter alia silicon nitride, zirconium-silicon nitride or tin-silicon nitride.

With respect to the contracting states DE, FR, GB and IT the present invention relates to following aspects:

In a first aspect it relates to a heat processable, metallic appearing coated article comprising:
(a) a transparent glass substrate;
(b) a metal compound film with metallic properties selected from the group consisting of metal borides, metal carbides, metal oxynitrides, chromium nitride, zirconium nitride, hafnium nitride, tantalum nitride, niobium nitride; and
(c) a protective layer comprising a different metal from the metal compound film which minimizes oxidation of the metal compound film and is selected from the group consisting of chromium, titanium, and nitrides and oxynitrides of silicon-metal alloys with the exception of silicon-zirconium nitride and silicon-tin nitride.

In a second aspect it relates to a heat processable, metallic appearing coated article comprising:
(a) a transparent glass substrate;
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of titanium, and nitrides and oxynitrides of silicon-metal alloys with the exception of silicon-zirconium nitride and silicon-tin nitride.

In a third aspect it relates to a method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride; and
(b) depositing a protective layer comprising a different metal from the metal compound film which minimizes oxidation of the metal compound film and is selected from the group consisting of chromium, titanium, and nitrides and oxynitrides of silicon-metal alloys with the exception of silicon-zirconium nitride and silicon-tin nitride; and
(c) heating the glass substrate on which are deposited said metal compound film and protective layer to a temperature sufficient to bend the glass;
whereby silicon-zirconium nitride and silicon-tin nitride was excluded by means of a disclaimer from the materials for the protective layer according to said first three aspects of the invention to delimit the subject matter of the present invention with respect to the overlapping contracting states DE, FR, GB and IT from EP-A-546 302.

In a fourth aspect it relates to a heat processable, metallic appearing coated article comprising:
(a) a transparent glass substrate;
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of chromium, titanium, and nitrides and oxynitrides of silicon and silicon-metal alloys;
wherein a stabilizing layer selected from the group consisting of silicon, titanium, zirconium, tantalum, chromium, niobium, silicon alloys, nickel-chromium alloys and aluminum nitride is deposited between said glass substrate and said metal compound film.

In a fifth aspect it relates to a method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride;
(b) depositing a protective layer comprising a different metal from the metal compound film which minimizes oxidation of the metal compound film and is selected from the group consisting of chromium, titanium, and nitrides and oxynitrides of silicon and silicon-metal alloys;
(c) heating the glass substrate on which are deposited said metal compound film and protective layer to a temperature sufficient to bend the glass,
further comprising the step of depositing a stabilizing layer selected from the group consisting of silicon, titanium, zirconium, tantalum, chromium, niobium, silicon alloys, nickel-chromium alloys and aluminum nitride, between said glass substrate and said metal compound film.

In a sixth aspect it relates to a heat processable, metallic appearing coated article comprising
(a) a transparent glass substrate
(b) a metal compound film with metallic properties which is titanium nitride
(c) a protective layer which is silicon nitride.

With respect to the contracting states CH, ES, LI, LU and SE the present invention relates to following aspects.

In a first aspect it relates to a heat processable, metallic appearing coated article comprising:
(a) a transparent glass substrate;
(b) a metal compound film with metallic properties selected from the group consisting of metal borides, metal carbides, metal oxynitrides, chromium nitride, zirconium nitride, hafnium nitride, tantalum nitride, niobium nitride; and
(c) a protective layer comprising a different metal from the metal compound film which minimizes oxidation of the metal compound film and is selected from the group consisting of chromium, titanium, and nitrides and oxynitrides of silicon and silicon-metal alloys.

In a second aspect it relates to a heat processable, metallic appearing coated article comprising:
(a) a transparent glass substrate;
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of titanium, and nitrides and oxynitrides of silicon and silicon-metal alloys.

In a third aspect it relates to a method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride; and
(b) depositing a protective layer comprising a different metal from the metal compound film which minimizes oxidation of the metal compound film and is selected from the group consisting of chromium, titanium, and nitrides and oxynitrides of silicon and silicon-metal alloys; and
(c) heating the glass substrate on which are deposited said metal compound film and protective layer to a temperature sufficient to bend the glass.

Vacuum coatings with a metallic appearance as deposited can be made to retain their metallic appearance upon bending by overcoating with a different metal which forms a dense oxide. Further improvement in oxidation resistance of the metallic film can be attained by introducing additional interfaces formed by another layer of a different material, particularly an amorphous metal oxide.

Vacuum coatings of metal compounds having metallic properties, such as titanium nitride, which retain their metallic properties when overcoated with a dielectric material, are stabilized for tempering by the addition of a malleable metal, alloy or semiconductor layers bellow the titanium nitride. Such an underlayer, which has a termal expansion coefficient equal to or less than that of the substrate, has good adhesion to the glass substrate and titanium nitride layer, eliminates the problems of haze, mottle, picture framing and surface contamination, and greatly increases the operating temperature range for tempering. Preferred underlayer materials include silicon, titanium, zirconium, tantalum, chromium, niobium, silicon alloys and nickel-chromium alloys.
Figure 1 compares the reflectance of a heated but unoxidized metallic layer in accordance with the present invention (A) with the reflectance of an unoxidized metal layer (B) and the reflectance of an unheated metallic layer (C).
Figure 2 compares the transmittance of a heated but unoxidized metallic layer in accordance with the present invention (A) with the transmittance of a heated oxidized matellix layer (B) and the transmittance of an unheated metallic layer (C).
Figure 3 illustrates a coated article of the present invention with substrate 10 coated with a first malleable metal-containing layer 20 which stabilizes a second metal compound layer 30 with metallic properties which in turn is protected from oxidation by a silicon-based dielectric layer 40.

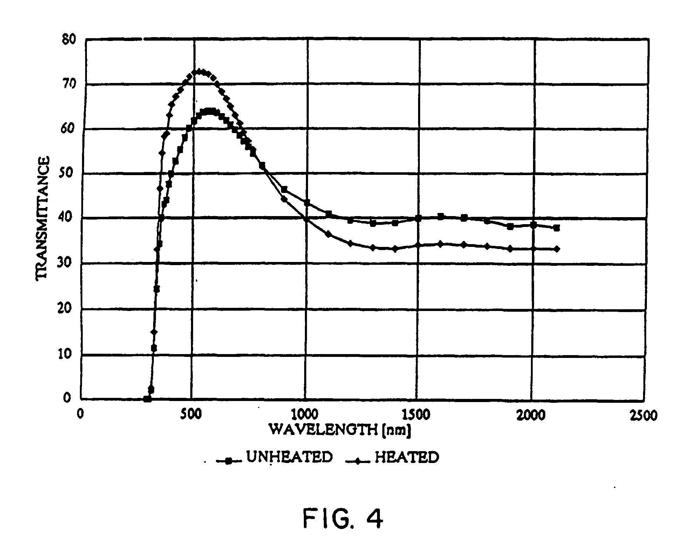

Figure 4 illustrates the transmittance as a function of wavelength for a coating of the present invention before and after heating at 704°C (1300°F) for 3.5 minutes.

In accordance with the present invention, some of the more oxidation resistant, coatings, preferably chromium nitride and titanium niride, which nevertheless normally oxidize quite quickly at 700°C, can be protected from such oxidation by another oxidation resistant metal. The protective layer must be dense to prevent oxidation of the underlying metallic layer. Since metal oxides are generally not sufficiently dense as deposited in vacuum, the protective layer is deposited as a metal which forms a dense oxide surface layer which prevents oxidation of the underlying material. The metal of the protective layer must be different from the metal of the metallic layer in order to prevent oxidation from proceeding through the interface. Thus, for example, a titanium protective layer will prevent oxidation of a chromium nitride layer, whereas a chromium layer will not.

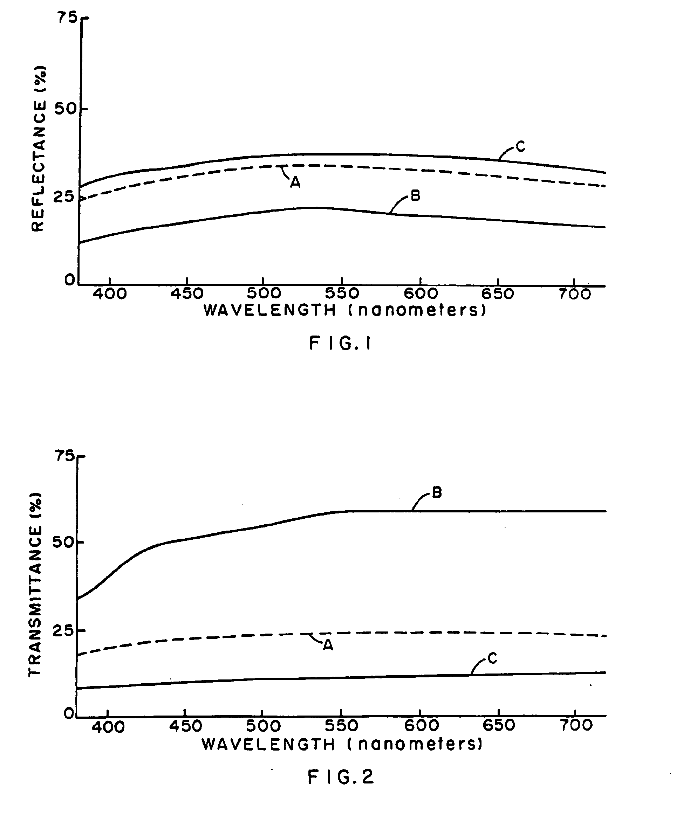

An unprotected coating oxidizes upon heating, which results in higher transmittance and lower reflectance than a metallic coating protected in accordance with the present invention, as shown in Figures 1 and 2, as well as a hazy and translucent appearance. In contrast, a metallic appearing vacuum coating of e.g. chromium nitride or titanium nitride, protectedb by a different oxidation resistant layer such as titanium in accordance with the present invention, will retain its characteristic metallic reflectance, transmittance and absorbence properties upon heating to glass bending temperatures as shown in Figures 1 and 2. The slightly lower reflectance and higher transmittance of the heated coating and the result of oxidation of the surface of the protective layer.

Further improvement in oxidation resistance can be attained by introducing additional interfaces formed by yet another different type of material. This material is preferably glassy, e.g. an amorphous metal oxide, such as zinc-tin oxide, preferably of approximate composition Zn₂SnO₄.

In order to use titanium nitride on a flat glass substrate which is subsequently tempered, it has now been discovered that it should not only be protected from oxidation by means of a protective overcoat layer, but preferably also should be stabilized, for example, against glass substrate-titanium nitride layer interaction or stress-induced "breakdown" which occur at the high temperatures required for tempering. For example, a coating of titanium nitride/silicon nitride made by a magnetron sputtering process, where the silicon nitride overcoat prevents oxidation of the titanium nitride, was found not to survive tempering for silison nitride layer thicknesses up to 800 Angstroms. Such a coating becomes hazy, mottled, crazed and develops a picture frame effect (coating breakdown around the edge of glass plate) after tempering. In addition, the coating is susceptible to glass surface contamination, such as packer belt marks, washer contamination in the form of streaks, or spots in the coating after heating.

In accordance with a preferred embodiment of the present invention, oxidation resistant metallic metal compound coatings, particularly titanium nitride, which nevertheless normally oxidize readily at 700°C, can be protected from such oxidation by dielectric oxides or nitrides if a stabilizing layer is deposited below the titanium nitride layer as well. These stabilizing layers should have good adhesion to the adjacent layers, be somewhat malleable and have thermal expension coefficients less than or equal to glass. The preferred stabilizing layers are silicon and silicon alloy, titanium, zirconium, tantalum, chromium, niobium, nickel-chromium and nickel-chromium containing alloys. Aluminum nitride can also be used as a stabilizing layer, particularly to maintain high transmittance. Silicon-aluminum as a stabilizing layer results in higher total solar energy transmittance (TSET) values than silison-nickel and aluminum nitride for the same value of luminous transmittance of illuminant A (LTA).

The stabilizing layer isolates the glass substrate from and provides a uniform controlled surface for the metallic metal compound layer. During the thermal process it prevents, for example, the titanium nitride layer from reacting with the glass surface and provides a mechanical transitional layer between the glass substrate ans the titanium nitride layer. The stabilizing layer reacts with the glass surface forming an oxide, thus increasing in transmission, and still maintains bonding to the metallic metal compound. The stabilizing layer should be thick enough to isolate the metallic metal compound layer from the glass, yet thin enough to oxidize and provide maximum transmission: since this layer does not significantly enhance solar properties. The thickness of the stabilizing layer is preferably in the range of 5 to 100 Angstroms. A preferred stabilizing layer is silicon, preferably in the thickness range of 20 to 50 Angstroms. Titanium is another preferred stabilizing layer particularly in the thickness range of 15 to 40 Angstroms.

Silicon alloy dielectrics selected from nitrides and oxynitrides are preferred for overcoats in accordance with the present invention. The silicon alloy dielectric used for the overcoat is critical in preventing coating breakdown during heating. Silicon can be alloyed or doped with many different elements. Each element adds some unique property to the silicon, either in the form of a target material for sputter deposition or in the form of a sputtered coating. In addition, target fabrication, either by casting or plasma spraying, is facilitated by alloying. In accordance with the present invention elements alloyed or doped with silicon include aluminum, nickel, chromium, iron, nickel-chromium alloys, boron, titanium and zirconium. The amount of other metal alloyed with silicon varies by metal and is limited only by the desired properties of the target and the coating. Typically up to 50 percent by weight of additional metal in silicon is usable, preferably 5 to 25 percent alloying metal and/or up to 2 percent dopant.

Sputtering a planar target of silicon-nickel, for example, is more stable, with a 40 percent higher sputtering rate than sputtering a planar target of silicon-aluminum in an oxygen-argon gas mixture, and the effect of 20 weight percent nickel on absorption and refractive index of an oxide coating is insignificant for the applications described here. Silicon-nickel, however, when sputtered as a nitride is absorbing, the degree depending on the amount of nickel, where silicon-aluminum nitride is not. When index variation or absorption are desirable, for example with a privacy type coating, the alloy content can be varied. This gives the added flexibility of an additional layer to vary optical properties and particularly to decrease transmission. Chromium and chromium-nickel alloys behave similarly to nickel, with added chemical durability, particularly for the nitride coating. Silicon-aluminum nitride, on the other hand, is not as chemically durable.

Generally, silicon alloy nitride and oxynitride coatings all provide durable overcoats which assist in preventing oxidation of the underlying metallic metal compound layer during a tempering process. Silicon-iron is most effective with an additional layer over the metallic metal compound. In addition, the process of heating during tempering further enhances the chemical and mechanical durability of these layers. A silicon-aluminum or silicon-nickel nitride or oxynitride overcoat, for example, is particularly effective. A silicon-iron nitride is most effective with an intermediate silicon-aluminum nitride, aluminum nitride, silicon or silicon alloy layer between the titanium nitride and silicon-iron nitride layers. Silicon alloy nitride protective overcoats are particularly effective in the range of 125 to 1000, preferably 200 to 800 Angstroms thick

Generally, for solar control glazing in automobiles, coating stacks typically consist of titanium nitride sandwiched between dielectric layers to form an interference coating stack and provide a protective overcoat. In accordance with the present invention, a stabilizing metal layer is inserted between the glass substrate and a layer of a metal compound with metallic properties. A preferred metal compound is titanium nitride, typically at a thickness of 20 to 1000 Angstroms, preferably at a thickness of 30 to 500 Angstroms. The metal compound layer is protected from oxidation by an overcoat of a dielectric material, preferably a silicon-based dielectric material. The coating is then stable in a bending or tempering process. The combination of these layers and the thermal processing enhance the properties of the coating. The solar properties of this tempered or bent coated glass with the stabilizing metal layer, titanium nitride and silicon alloy dielectric material are always superior to the equivalent unheated coating with no stabilizing layer. Preferred silicon-based dielectric materials are the nitrides and oxynitrides of silcon and silicon alloys containing, e.g. aluminum, nickel and/or chromium.

Combinations of nitride and oxynitride layers may also be used as overcoats, however, in areas that do not have luminous transmittance (LTA) requirements of greater than 70 percent. Silicon nitride or combinations of nitride or oxynitride as overcoat layers offer durable coatings with increased flexibility in the choice of color and reflectance. These overcoats have particular application for privacy glazing with enhanced solar properties.

The preferred coated articles of the present invention have the general configuration

glass/M1/M3/silicon(M2)dielectric

where M1 is a semiconductor or metal alloy or combination thereof, M2 is an element combined with silicon in the silicon alloy target, and M3 is the metallic metal compound to be protected from oxidation and stabilized during high temperature processing such as tempering. An optional intermediate layer may be deposited between the metal compound and the silicon-based dielectric material.

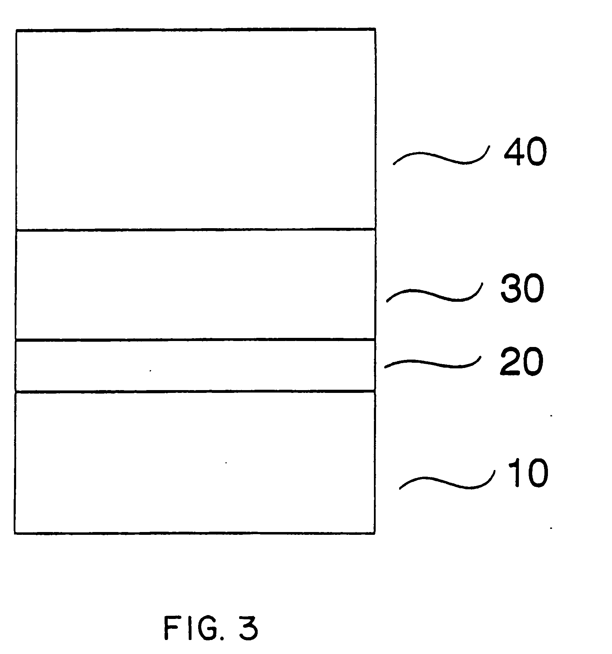

With reference to Figure 3, a glass substrate (10) is coated by sputtering, first, a stabilizing layer (20) whose function is to prevent coating breakdown during high temperature processing. This is followed by a metallic metal compound layer (30) with metallic properties whose function is primarily to reduce solar heat load, and secondarily to fulfill aesthetic requirements. This layer may be followed by an optional intermediate layer (not shown) the function of which is to enhance, if needed, the performance of the protective overcoat and, optionally, to give increased flexibility in coating aesthetics and transmittance. Following this layer is the dielectric protective overcoat layer (40) whose function is to prevent oxidation of the metallic compound layer during high temperature processing and to provide a durable overcoat.

The stabilizing layer is preferably selected from the group consisting of silicon, titanium, zirconium, tantalum, chromium, niobium, silicon alloys, nickel-chromium alloys and aluminum nitride. The metal compound layer (30) with metallic properties, the function of which is primarily to reduce solar heat load and secondarily to provide aesthetics requirements, is selected from the group consisting of metal borides, chromium nitride, zirconium nitride, hafnium nitride, tantalum nitride, niobium nitride, titanium nitride, metal carbides and metal oxynitrides. The optional intermediate layer is preferably selected from the group consisting of silicon, titanium, silicon metal alloys and oxides, nitrides and oxynitrides thereof. Finally, the dielectric protective overcoat layer (40), the function of which is to prevent coating breakdown during high temperature processing and to provide a durable overcoat, is preferably selected from the group consisting of nitrides and oxynitrides of silicon and silicon-metal alloys.

Additionally, to provide flexibility in controlling color, reflectance and transmittance along with meeting solar property requirements, optional layers can be sputtered. For example, a silicon nitride layer can be inserted between the stabilizing layer (20) and the metallic metal compound layer (30). Other optional layer sequences are stacking the metallic metal compound layers alternatively with the group selected for the stabilizing layer and, adding a metal layer over the protective overcoat layer (40). Layers can also be repeated, for example, additional metallic metal compound layer followed by protective overcoat layer can be sputtered over the protective overcoat layer (40).

In preferred embodiments of the present invention, the coatings are produced on a large-scale magnetron sputtering device capable of coating glass up to 2.54 X 3.66 meters (100 X 144 inches). In the following examples, the coatings are deposited on a smaller scale, using planar magnetron cathodes having 12.7 X 43.2 centimeter (5 X 17 inch) metal targets of e.g. chromium or titanium, or a 7.6 centimeter (3 inch) diameter rotating cathode of silicon or silicon alloy. In each example, 6 millimeter thick glass substrates pass the targets on a conveyor roll at a speed of 3.05 meters (120 inches) per minute. Base pressure is in the 1.33 x 10⁻⁴ Pa (10⁻⁶ Torr) range.

The coatings are made by first admitting the sputtering gas to a pressure of 0.53 Pa (4 millitorr) and then setting the cathode to a constant power. In each example, except where noted otherwise, 6 millimeter thick glass substrates pass under the targets on a conveyor roll at a speed of 3.05 meters (120 inches) per minute unless otherwise specified. This procedure is repeated for each layer in the configuration.

The coatings are tested for thermal stability by hanging 5.1 X 30.5 centimeter (2 X 12 inch) strips of coated 6.0 mm clear glass on tongs and lifting them into a 1.2 X 0.76 X 0.3 meter (48 X 30 X 12 inch) vertical "loft" furnace heated to 705°C. The strips are heated for 3.5 minutes, except where noted otherwise, to simulate tempering. Air quenching in the tempering process does not cause any coating degradation. To determine compatibility with a production process, coated glass plates 0.3 meter (12 inches) square were edged, washed, screened with a black band frit and tempered on vertical and horizontal furnaces. The coating properties were checked for transmittance, reflectance, color, and the solar properties of total solar energy transmittance and total solar infrared transmittance (TSET and TSIR). Taber abrasion tests were performed and percent haze recorded.

The invention will be further understood from the descriptions of specific examples which follow.

### EXAMPLE 1 (comparison example)

A coating of chromium nitride about 380 Angstroms thick is made by sputtering a chromium metal target (2 passes) at 7.5 kilowatts, 587 volts in pure nitrogen gas at a pressure of 0.53 Pa (4 millitorr) until the luminous transmission is 9%. The coated glass is then heated for 10 minutes at 570°C. The coating is oxidized by the heat, and its transmittance curve is similar to B in Figure 2.

### EXAMPLE 2

For comparison with Example 1, a coating of chromium nitride about 380 Angstroms thick is made by sputtering a chromium metal target (2 passes) at 7.5 kilowatts, 586 volts in pure nitrogen gas until the luminous transmission is 10%. Then a layer of titanium metal about 40 Angstroms thick is deposited by sputtering a titanium target (one pass) at 0.5 kilowatts, 346 volts, until the transmission of the sample decreases to 8.9%. The sample is heated for 10 minutes at 570°C and the coating, although its transmittance increases slightly, still has a metallic appearance, and shows spectrophotometric curves similar to (A) in Figures 1 and 2. When heated for 10 minutes at 625°C the coating oxidizes.

### EXAMPLE 3

A film of chromium nitride about 380 Angstroms thick applied as in the above examples to 9.6% transmission is overcoated with a layer about 60 Angstroms thick of zinc/tin oxide of approximate composition Zn₂SnO₄ made by sputtering a zinc-tin alloy target of Zn-2Sn composition at 1.8 kilowatts, 346 volts in a mixture of 50% oxygen, 50% argon by volume. The transmittance is 10.2%. Finally a layer of titanium metal about 40 Angstroms thick is applied as in Example 2 until the transmittance is 8.7%. The coating remains metallic in appearance after heating for 10 minutes at 570°C and 10 minutes at 625°C.

### EXAMPLE 4 (comparison example)

A layer of titanium nitride about 450 Angstroms thick is deposited by sputtering a titanium metal target in pure nitrogen gas at a pressure of 4 millitorr. The voltage is 764 volts and the power 8 kilowatts. After 4 passes the transmittance is 23.5% The color is bluish metallic. After heating in air for 10 minutes at 570°C, the coating is completely oxidized.

### EXAMPLE 5

A layer of titanium nitride about 470 Angstroms thick is applied as in Example 4. The transmittance is 22.8%. A layer of silicon nitride about 100 Angstroms thick is applied from a C-Mag cathode as in Example 7, by sputtering a silicon target at 3 kilowatts, 416 volts in pure nitrogen gas at 4 millitorr. The transmittance rises to 25% after a single pass. The appearance of the sample is unchanged after heating for 10 minutes at 625°C.

### EXAMPLE 6

A titanium layer is deposited by sputtering a planar titanium cathode in argon at 0.6 kilowatts, 332 volts, to a transmission of 62 percent (1 pass), followed by 9 passes using a planar titanium cathode in pure nitrogen at 4.0 kilowatts, 536 volts, to a transmission of 18.5 percent, followed by 5 passes using a rotating cathode with silicon-5% aluminum in pure nitrogen at 2.8 kilowatts, 473 volts to a transmission of 23 percent. The coating thicknesses for each individual layer in Angstroms are 25 Angstroms titanium, 400 Angstroms titanium nitride and 270 Angstroms silicon-5% aluminum nitride. The properties on clear glass, before and after heating, are the following:

| C. I. E. CHROMATICITY COORDINATES | | | |
|---|---|---|---|
| (1931 2 degree observer) | | | |
| | Reflectance | Unheated | Heated |
| | (Illuminant D65) | | |
| Film Side | Y | 13.59% | 10.31% |
| | x | .357 | .3264 |
| | y | .3767 | .3411 |
| Glass Side | Y | 29.25% | 19.11% |
| | x | .3042 | .2945 |
| | y | .3366 | .3234 |

| | Transmittance (Illuminant A) | | |
|---|---|---|---|
| | Y | 24.11% | 34.7% |
| | x | .4479 | .4387 |
| | y | .4156 | .4165 |
| | TSET | 17.9% | 21.7% |
| | TSIR | 10.7% | 10.3% |

The transmitted total solar infrared radiation (TSIR) shows that the titanium nitride does not degrade after heating, but instead is slightly enhanced. This is also evident in the wavelength region greater than 900 nm where TSIR is up to 1 percent lower than the unheated sample. The abrasion resistance after heating is well below the required 2 percent haze limit for glass. The before heat scratch resistance is more than sufficient to survive the complete manufacturing tempering process (cutting, edging, washing, screening, and tempering) with no scratching or coating degradation.

This coating applied to 4.0 millimeter Solargray^{®} glass for privacy glazing in automotive sidelights and backlights reduces luminous transmittance to approximately 20 percent and total solar transmittance to 13 percent.

### EXAMPLE 7

A coated article having the configuration

glass/Si-5%Al/Ti nitride/Si-5%Al nitride

is prepared as follows:

The first layer is deposited by sputtering a planar silicon-5% Al cathode in argon at 0.4 kilowatts, 500 volts, to a transmission of 81.4 percent (1 pass), followed by 1 pass at 2.3 meters (90 inches) per minute using a planar titanium cathode in pure nitrogen at 6.0 kilowatts, 596 volts, to a transmission of 53.7 percent, followed by 12 passes using a planar cathode with silicon-5% Al in pure nitrogen at 3.0 kilowatts, 348 volts to a transmission of 63.2 percent.

The coated article is stable with tempering with a Si-5% Al thickness greater than or equal to 25 Angstroms for a Si-5% Al nitride layer greater than or equal to 125 Angstroms.

### EXAMPLE 8

A coated article prepared as in Example 7, but having the configuration

glass/Si-8%Fe-.25%B/Ti nitride/Al nitride/Si-8%Fe-.25%B nitride

is stable with tempering with a Si-8%Fe-.25%B thickness of 25 Angstroms, aluminum nitride thickness of 80 Angstroms, and a Si-8%Fe-.25%B nitride thickness of 200 Angstroms. Although aluminum nitride dissolves in water, for a coating with the above configuration, the unheated coating survives boiling in water for 30 minutes and is stable with tempering. The heated coating also survives boiling for 30 minutes. Si-8%Fe-.25%B is used when absorption is desirable in the coating, for example in privacy glazing.

### EXAMPLE 9

A coated article is prepared as in the previous examples, having the configuration

glass/Si-8%Fe-.25%B/Ti nitride/Si-8%Fe-.25%B/Si-8%Fe-.25%B nitride.

The coating is stable with tempering for Si-8%Fe-25%B thicknesses of 25 Angstroms and Si-8%Fe-.25%B nitride thickness of 350 Angstroms. The additional layer gives increased flexibility in varying color, transmittance and reflectance in addition to thermal stability.

### EXAMPLE 10

Coatings are prepared as in the previous examples, having the configuration

glass/Ti/Ti nitride/Si-1396Al nitride or oxynitride.

These coatings illustrate the differences between the Si-M2 nitride and oxynitride overcoats. Both of these coatings are stable with tempering. The first three layers of both coatings are made by sputtering on 6 millimeter clear glass the layers as described in Example 1, except the 9 passes of the titanium nitride layer were sputtered at 4.4 kilowatts, 543 volts to a transmission of 16.5 percent. The thickness of the titanium nitride layer was 440 Angstroms. Both overcoat layers were then sputtered to the same physical thicknesses of 220 Angstroms. The Si-13%Al nitride overcoat layer was made by sputtering 5 passes from a planar cathode in pure nitrogen at 3.0 kilowatts, 456 volts to a final transmission of 19.7 percent. The Si-13%Al oxynitride layer was made by sputtering 5 passes from the same planar cathode in a 6 percent oxygen - nitrogen mix at 2.6 kilowatts, 450 volts to a final transmission of 18.9 percent. The CIE color coordinates were then compared for the coating after heating on both the film and glass sides.

| | Reflectance | Nitride | Oxynitride |
|---|---|---|---|
| Film Side | Y(D65) | 12.08% | 15.42% |
| | x | .3292 | .3341 |
| | y | .3311 | .3288 |
| Glass Side | Y(D65) | 20.2% | 17,94% |
| | x | .2973 | .2977 |
| | y | .3219 | .3114 |

From the above results it can be seen that as the overcoat with constant physical thickness goes from nitride to oxynitride there is a color shift and change in reflectance due to change in the coating index.

### EXAMPLE 11

A coated article prepared as in the previous examples having the configuration

glass/Si-7.5%Ni/Ti nitride/Si-10%Cr nitride

is stable after tempering, for example, with the Si-10%Cr nitride layer in the thickness range 290 Angstroms to 1050 Angstroms for titanium nitride layer thickness of 100 Angstroms and Si-7.5%Ni layer thickness of 34 Angstroms.

The first two layers of this coating are made by sputtering on 6.0 millimeter clear glass as described in Example 4. The third layer is made by sputtering 4 passes from a planar Si-10%Cr cathode in pure nitrogen at 3.0 kilowatts, 510 volts to a final transmission of 53.1 percent. The thickness of this layer is 290 Angstroms.

The above examples are offered only to illustrate the present invention. Other metal nitride and metal carbide metallic appearing films may be protected from oxidation by dense oxide surface forming metal layers as described above. Other metal nitride, metal carbide and metal boride metallic films and composition ranges may be used as the metallic metal compound layer with other oxynitride and nitride layers used as the protective overcoat, and other stabilizing metal layers. Deposition conditions will vary according to equipment and material being deposited. Coating thicknesses can be varied to produce the desired reflectance and transmittance properties.

## Claims (Claims for the following Contracting State(s): DE, FR, GB, IT)

1. A heat processable, metallic appearing coated article comprising:
(a) a transparent glass substrate;
(b) a metal compound film with metallic properties selected from the group consisting of metal borides, metal carbides, metal oxynitrides, chromium nitride, zirconium nitride, hafnium nitride, tantalum nitride, niobium nitride; and
(c) a protective layer comprising a different metal from the metal compound film which minimizes oxidation of the metal compound film and is selected from the group consisting of chromium, titanium, and nitrides and oxynitrides of silicon-metal alloys with the exception of silicon-zirconium nitride and silicon-tin nitride.

2. A heat processable, metallic appearing coated article comprising:
(a) a transparent glass substrate:
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of titanium, and nitrides and oxynitrides of silicon-metal alloys with the exception of silicon-zirconium nitride and silicon-tin nitride.

3. A coated article according to claim 1, wherein the metal compound film is chromium nitride.

4. A coated article according to claim 2, wherein the metal compound film is selected from the group consisting of chromium nitride and titanium nitride.

5. A coated article according to claim 1, wherein the protective layer is selected from the group consisting of chromium and titanium.

6. A coated article according to claim 2, wherein the protective layer is titanium.

7. A coated article according to claim 1 or 2, wherein the metal compound film is chromium nitride and the protective layer is titanium.

8. A coated article according to any of claims 1-7, wherein an amorphous metal oxide layer is deposited between the metal compound film and the protective layer.

9. A coated article according to claim 8, wherein said amorphous metal oxide layer comprises zinc and tin.

10. A coated article according to claim 9, wherein the metal compound film is selected from the group consisting of chromium nitride and titanium nitride, the protective layer is titanium, and the amorphous metal oxide layer has the approximate composition Zn₂SnO₄.

11. A heat processable, metallic appearing coated article comprising:
(a) a transparent glass substrate:
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of chromium, titanium, and nitrides and oxynitrides of silicon and silicon-metal alloys;
wherein a stabilizing layer selected from the group consisting of silicon, titanium, zirconium, tantalum, chromium, niobium, silicon alloys, nickel-chromium alloys and aluminum nitride is deposited between said glass substrate and said metal compound film.

12. A coated article according to claim 11, wherein the protective layer is selected from the group consisting of nitrides and oxynitrides of silicon and silicon-metal alloys.

13. A coated article according to claims 11 or 12, wherein the metal compound film is selected from the group consisting of chromium nitride, titanium nitride, titanium boride, titanium carbide, zirconium nitride, hafnium nitride, tantalum nitride, niobium nitride, titanium oxynitride, zirconium oxynitride, chromium oxynitride, tantalum oxynitride, and niobium oxynitride.

14. A coated article according to claim 12, wherein the protective layer is selected from the group consisting of silicon nitride, silicon oxynitride, silicon-nickel nitride, silicon-nickel oxynitride, silicon-aluminum nitride, silicon-aluminum oxynitride, silicon-iron nitride, silicon-iron oxynitride, silicon-chromium nitride, silicon-chromium oxynitride, silicon-nickel-chromium nitride, silicon-nickel-chromium oxynitride, silicon-boron nitride and silicon-boron oxynitride.

15. A coated article according to claim 11, wherein the stabilizing layer contains a metal selected from the group consisting of silicon and titanium, the metal compound film comprises titanium nitride, and the protective layer comprises silicon nitride or oxynitride.

16. A coated article according to claim 11, wherein the stabilizing layer is a silicon-metal alloy or titanium, the metal compound film is titanium nitride and the protective layer is selected from the group consisting of silicon-metal alloy nitride and silicon-metal alloy oxynitride.

17. A coated article according to any of claims 12-16, wherein an additional layer is deposited between the metal compound film and the protective layer.

18. A coated article according to claim 17, wherein said additional layer is selected from the group consisting of silicon, titanium, silicon-metal alloys and oxides, nitrides and oxynitrides thereof.

19. A coated article according to claim 17, wherein the stabilizing layer comprises silicon or titanium, the metal compound film is titanium nitride, the additional layer is selected from the group consisting of silicon, titanium, silicon-metal alloy and aluminum nitride, and the protective layer is selected from the group consisting of silicon nitride, silicon oxynitride, silicon-nickel nitride, silicon-nickel oxynitride, silicon-aluminum nitride, silicon-aluminum oxynitride, silicon-iron nitride, silicon-iron oxynitride, silicon-chromium nitride, silicon-chromium oxynitride: silicon-nickel-chromium nitride, silicon-nickel-chromium oxynitride, silicon-boron nitride, and silicon boron oxynitride.

20. A method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride; and
(b) depositing a protective layer comprising a different metal from the metal compound film which minimizes oxidation of the metal compound film and is selected from the group consisting of chromium, titanium, and nitrides and oxynitrides of silicon-metal alloys with the exception of silicon-zirconium nitride and silicon-tin nitride: and
(c) heating the glass substrate on which are deposited said metal compound film and protective layer to a temperature sufficient to bend the glass.

21. A method according to claim 20, further comprising the step of depositing an amorphous metal oxide between said metal compound film and said protective layer.

22. A method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride;
(b) depositing a protective layer comprising a different metal from the metal compound film which minimizes oxidation of the metal compound film and is selected from the group consisting of chromium, titanium, and nitrides and oxynitrides of silicon and silicon-metal alloys:
(c) heating the glass substrate on which are deposited said metal compound film and protective layer to a temperature sufficient to bend the glass,
further comprising the step of depositing a stabilizing layer selected from the group consisting of silicon, titanium, zirconium, tantalum, chromium, niobium, silicon alloys, nickel-chromium alloys and aluminum nitride, between said glass substrate and said metal compound film.

23. A method according to claim 22, further comprising the step of depositing an additional layer between the metal compound film and the protective layer.

24. A method according to claim 23. wherein said additional layer is selected from the group consisting of silicon, titanium, a silicon-metal alloy, nitrides, oxides and oxynitrides thereof.

25. A heat processable, metallic appearing coated article comprising
(a) a transparent glass substrate
(b) a metal compound film with metallic properties which is titanium nitride
(c) a protective layer which is silicon nitride.

## Claims (Claims for the following Contracting State(s): CH, ES, LI, LU, SE)

1. A heat processable, metallic appearing coated article comprising:
(a) a transparent glass substrate;
(b) a metal compound film with metallic properties selected from the group consisting of metal borides, metal carbides, metal oxynitrides, chromium nitride, zirconium nitride, hafnium nitride, tantalum nitride, niobium nitride: and
(c) a protective layer comprising a different metal from the metal compound film which minimizes oxidation of the metal compound film and is selected from the group consisting of chromium, titanium, and nitrides and oxynitrides of silicon and silicon-metal alloys.

2. A heat processable, metallic appearing coated article comprising:
(a) a transparent glass substrate:
(b) a metal compound film with metallic properties selected from the group consisting of metal borides, metal carbides, metal oxynitrides, chromium nitride, titanium nitride, zirconium nitride, hafnium nitride, tantalum nitride, niobium nitride; and
(c) a protective layer comprising a different metal from the metal compound film which minimizes oxidation of the metal compound film and is selected from the group consisting of titanium, and nitrides and oxynitrides of silicon and silicon-metal alloys.

3. A coated article according to claim 1, wherein the metal compound film is chromium nitride.

4. A coated article according to claim 2, wherein the metal compound film is selected from the group consisting of chromium nitride and titanium nitride.

5. A coated article according to claim 1, wherein the protective layer is selected from the group consisting of chromium and titanium.

6. A coated article according to claim 2, wherein the protective layer is titanium.

7. A coated article according to claim 1 or 2, wherein the metal compound film is chromium nitride and the protective layer is titanium.

8. A coated article according to any of claims 1-7, wherein an amorphous metal oxide layer is deposited between the metal compound film and the protective layer.

9. A coated article according to claim 8, wherein said amorphous metal oxide layer comprises zinc and tin.

10. A coated article according to claim 9, wherein the metal compound film is selected from the group consisting of chromium nitride and titanium nitride, the protective layer is titanium, and the amorphous metal oxide layer has the approximate composition Zn₂SnO₄.

11. A coated article according to claim 1 or 2, wherein a stabilizing layer selected from the group consisting of silicon, titanium, zirconium, tantalum, chromium, niobium, silicon alloys, nickel-chromium alloys and aluminum nitride, is deposited between said glass substrate and said metal compound film.

12. A coated article according to claim 11, wherein the protective layer is selected from the group consisting of nitrides, and oxynitrides of silicon and silicon-metal alloys.

13. A coated article according to claims 11 or 12, wherein the metal compound film is selected from the group consisting of chromium nitride, titanium nitride, titanium boride, titanium carbide, zirconium nitride, hafnium nitride, tantalum nitride, niobium nitride, titanium oxynitride, zirconium oxynitride, chromium oxynitride, tantalum oxynitride, and niobium oxynitride.

14. A coated article according to claim 12, wherein the protective layer is selected from the group consisting of silicon nitride, silicon oxynitride, silicon-nickel nitride, silicon-nickel oxynitride, silicon-aluminum nitride, silicon-aluminum oxynitride, silicon-iron nitride, silicon-iron oxynitride, silicon-chromium nitride, silicon-chromium oxynitride, silicon-nickel-chromium nitride, silicon-nickel-chromium oxynitride, silicon-boron nitride and silicon-boron oxynitride.

15. A coated article according to claim 11, wherein the stabilizing layer contains a metal selected from the group consisting of silicon and titanium, the metal compound film comprises titanium nitride, and the protective layer comprises silicon nitride or oxynitride.

16. A coated article according to claim 11, wherein the stabilizing layer is a silicon-metal alloy or titanium, the metal compound film is titanium nitride and the protective layer is selected from the group consisting of silicon-metal alloy nitride and silicon-metal alloy oxynitride.

17. A coated article according to any of claims 12-16, wherein an additional layer is deposited between the metal compound film and the protective layer.

18. A coated article according to claim 17, wherein said additional layer is selected from the group consisting of silicon, titanium, silicon-metal alloys and oxides, nitrides and oxynitrides thereof.

19. A coated article according to claim 17, wherein the stabilizing layer comprises silicon or titanium, the metal compound film is titanium nitride, the additional layer is selected from the group consisting of silicon, titanium, silicon-metal alloy and aluminum nitride, and the protective layer is selected from the group consisting of silicon nitride, silicon oxynitride, silicon-nickel nitride, silicon-nickel oxynitride, silicon-aluminum nitride, silicon-aluminum oxynitride, silicon-iron nitride, silicon-iron oxynitride, silicon-chromium nitride, silicon-chromium oxynitride, silicon-nickel-chromium nitride, silicon-nickel-chromium oxynitride, silicon-boron nitride and silicon-boron oxynitride.

20. A method of making a heat processed metallic appearing article comprising the steps of:
(a) depositing on a surface of a glass substrate a metal compound film with metallic properties selected from the group consisting of metal borides, metal carbides, metal oxynitrides, chromium nitride, titanium nitride, zirconium nitride, hafnium nitride, tantalum nitride, niobium nitride; and
(b) depositing a protective layer comprising a different metal from the metal compound film which minimizes oxidation of the metal compound film and is selected from the group consisting of chromium, titanium, and nitrides and oxynitrides of silicon and silicon-metal alloys: and
(c) heating the glass substrate on which are deposited said metal compound film and protective layer to a temperature sufficient to bend the glass.

21. A method according to claim 20, further comprising the step of depositing an amorphous metal oxide between said metal compound film and said protective layer.

22. A method according to claim 20, further comprising the step of depositing a stabilizing layer selected from the group consisting of silicon, titanium, zirconium, tantalum, chromium, niobium, silicon alloys, nickel-chromium alloys and aluminum nitride, between said glass substrate and said metal compound film.

23. A method according to claim 22, further comprising the step of depositing an additional layer between the metal compound film and the protective layer.

24. A method according to claim 23, wherein said additional layer is selected from the group consisting of silicon, titanium, a silicon-metal alloy, nitrides, oxides and oxynitrides thereof.

## Patentansprüche (Patentansprüche für folgende(n) Vertragsstaat(en): DE, FR, GB, IT)

1. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, ausgewählt aus der Gruppe bestehend aus Metallboriden, Metallcarbiden, Metalloxynitriden, Chromnitrid, Zirconiumnitrid, Hafniumnitrid, Tantalnitrid, Niobnitrid, und
(c) eine Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Chrom, Titan und Nitriden und Oxynitriden von Silicium-Metall-Legierungen, mit Ausnahme von Silicium-Zirconium-Nitrid und Silicium-Zinn-Nitrid.

2. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid, und
(c) eine Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Titan und Nitriden und Oxynitriden von Silicium-Metall-Legierungen, mit Ausnahme von Silicium- Zirconium-Nitrid und Silicium-Zinn-Nitrid.

3. Beschichteter Gegenstand nach Anspruch 1, bei dem der Film aus der Metallverbindung Chromnitrid ist.

4. Beschichteter Gegenstand nach Anspruch 2, bei dem der Film aus der Metallverbindung ausgewählt ist aus der Gruppe bestehend aus Chromnitrid und Titannitrid.

5. Beschichteter Gegenstand nach Anspruch 1, wobei die Schutzschicht ausgewählt ist aus der Gruppe bestehend aus Chrom und Titan.

6. Beschichteter Gegenstand nach Anspruch 2, wobei die Schutzschicht Titan ist.

7. Beschichteter Gegenstand nach Anspruch 1 oder 2, wobei der Film aus der Metallverbindung Chromnitrid ist und die Schutzschicht Titan ist.

8. Beschichteter Gegenstand nach einem der Ansprüche 1-7, wobei eine amorphe Metalloxidschicht zwischen dem Film aus der Metallverbindung und der Schutzschicht abgeschieden ist.

9. Beschichteter Gegenstand nach Anspruch 8, wobei diese amorphe Metalloxidschicht Zink und Zinn enthält.

10. Beschichteter Gegenstand nach Anspruch 9, wobei der Film aus der Metallverbindung ausgewählt ist aus der Gruppe bestehend aus Chromnitrid und Titannitrid, die Schutzschicht Titan ist und die amorphe Metalloxidschicht die angenäherte Zusammensetzung Zn₂SnO₄ aufweist.

11. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid und
(c) eine Schutzschicht, die ein zu dem Metall der Metallverbindung des Films unterschiedliches Metall enthält und die Oxidation des Films aus einer Metallverbindung minimiert und ausgewählt ist aus der Gruppe bestehend aus Chrom, Titan und Nitriden und Oxynitriden von Silicium und Silicium-Metall-Legierungen,
wobei eine stabilisierende Schicht, ausgewählt aus der Gruppe bestehend aus Silicium, Titan, Zirconium, Tantal, Chrom, Niob, Siliciumlegierungen, Nickel-Chrom-Legierungen und Aluminiumnitrid, zwischen diesem Glassubstrat und diesem Film aus der Metallverbindung abgeschieden ist.

12. Beschichteter Gegenstand nach Anspruch 11, wobei die Schutzschicht ausgewählt ist aus der Gruppe bestehend aus Nitriden und Oxynitriden von Silicium und Silicium-Metall-Legierungen.

13. Beschichteter Gegenstand nach Anspruch 11 oder 12, wobei der Film aus der Metallverbindung ausgewählt aus der Gruppe bestehend aus Chromnitrid, Titannitrid, Titanborid, Titancarbid, Zirconiumnitrid, Hafniumnitrid, Tantalnitrid, Niobnitrid, Titanoxynitrid, Zirconiumoxynitrid, Chromoxynitrid, Tantaloxynitrid und Nioboxynitrid.

14. Beschichteter Gegenstand nach Anspruch 12, wobei die Schutzschicht ausgewählt ist aus der Gruppe bestehend aus Siliciumnitrid, Siliciumoxynitrid, Silicium-Nickel-Nitrid, Silicium-Nickel-Oxynitrid, Silicium-Aluminium-Nitrid, Silicium-Aluminium-Oxynitrid, Silicium-Eisen-Nitrid, Silicium-Eisen-Oxynitrid, Silicium-Chrom-Nitrid, Silicium-Chrom-Oxynitrid, Silicium-Nickel-Chrom-Nitrid, Silicium-Nickel-Chrom-Oxynitrid, Silicium-Bor-Nitrid und Silicium-Bor-Oxynitrid.

15. Beschichteter Gegenstand nach Anspruch 11, wobei die stabilisierende Schicht ein Metall enthält, das ausgewählt ist aus der Gruppe bestehend aus Silicium und Titan, der Film aus der Metallverbindung Titannitrid enthält und die Schutzschicht Siliciumnitrid oder -oxynitrid enthält.

16. Beschichteter Gegenstand nach Anspruch 11, wobei die stabilisierende Schicht eine Silicium-Metall-Legierung oder Titan ist, der Film aus der Metallverbindung Titannitrid ist und die Schutzschicht ausgewählt ist aus der Gruppe bestehend aus Nitriden von Silicium-Metall-Legierungen und Oxynitriden von Silicium-Metall-Legierungen.

17. Beschichteter Gegenstand nach einem der Ansprüche 12-16, wobei eine zusätzliche Schicht zwischen dem Film aus der Metallverbindung und der Schutzschicht abgeschieden ist.

18. Beschichteter Gegenstand nach Anspruch 17, wobei diese zusätzliche Schicht ausgewählt ist aus der Gruppe bestehend aus Silicium, Titan, Silicium-Metall-Legierungen und Oxiden, Nitriden und Oxynitriden davon.

19. Beschichteter Gegenstand nach Anspruch 17, wobei die stabilisierende Schicht Silicium oder Titan enthält, der Film aus der Metallverbindung Titannitrid ist, die zusätzliche Schicht ausgewählt ist aus der Gruppe bestehend aus Silicium, Titan, Silicium-Metall-Legierungen und Aluminiumnitrid und die Schutzschicht ausgewählt ist aus der Gruppe bestehend aus Siliciumnitrid, Siliciumoxynitrid, Silicium-Nickel-Nitrid, Silicium-Nickel-Oxynitrid, Silicium-Aluminium-Nitrid, Silicium-Aluminium-Oxynitrid, Silicium-Eisen-Nitrid, Silicium-Eisen-Oxynitrid, Silicium-Chrom-Nitrid, Silicium-Chrom-Oxynitrid, Silicium-Nickel-Chrom-Nitrid, Silicium-Nickel-Chrom-Oxynitrid, Silicium-Bor-Nitrid und Silicium-Bor-Oxynitrid.

20. Verfahren zur Herstellung eines heiß bearbeiteten metallisch aussehenden Gegenstands, umfassend die Schritte:
(a) Abscheiden eines Films aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid, auf einer Oberfläche eines Glassubstrats und
(b) Abscheiden einer Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Chrom, Titan und Nitriden und Oxynitriden von Silicium-Metall-Legierungen, mit der Ausnahme von Silicium-Zirconium-Nitrid und Silicium-Zinn-Nitrid, und
(c) Erhitzen des Glassubstrats, auf dem dieser Film aus der Metallverbindung und diese Schutzschicht abgeschieden sind, auf eine Temperatur, die ausreicht, um das Glas zu biegen.

21. Verfahren nach Anspruch 20, das zusätzlich den Schritt des Abscheidens eines amorphen Metalloxids zwischen diesem Film aus der Metallverbindung und dieser Schutzschicht umfasst.

22. Verfahren zur Herstellung eines heiß bearbeiteten metallisch aussehenden Gegenstands, umfassend die Schritte:
(a) Abscheiden eines Films aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid, auf einer Oberfläche eines Glassubstrats,
(b) Abscheiden einer Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Chrom, Titan und Nitriden und Oxynitriden von Silicium und Silicium-Metall-Legierungen,
(c) Erhitzen des Glassubstrats, auf dem dieser Film aus der Metallverbindung und diese Schutzschicht abgeschieden sind, auf eine Temperatur, die ausreicht, um das Glas zu biegen,
wobei das Verfahren zusätzlich den Schritt des Abscheidens einer stabilisierenden Schicht, ausgewählt aus der Gruppe bestehend aus Silicium, Titan, Zirconium, Tantal, Chrom, Niob, Siliciumlegierungen, Nickel-Chrom-Legierungen und Aluminiumnitrid, zwischen diesem Glassubstrat und diesem Film aus der Metallverbindung umfasst.

23. Verfahren nach Anspruch 22, das zusätzlich den Schritt des Abscheidens einer zusätzlichen Schicht zwischen dem Film aus der Metallverbindung und der Schutzschicht umfasst.

24. Verfahren nach Anspruch 23, wobei diese zusätzlichen Schicht ausgewählt ist aus der Gruppe bestehend aus Silicium, Titan, einer Silicium-Metall-Legierung, Nitriden, Oxiden und Oxynitriden davon.

25. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, der Titannitrid ist,
(c) eine Schutzschicht, die Siliciumnitrid ist.

## Patentansprüche (Patentansprüche für folgende(n) Vertragsstaat(en): CH, ES, LI, LU, SE)

1. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, ausgewählt aus der Gruppe bestehend aus Metallboriden, Metallcarbiden, Metalloxynitriden, Chromnitrid, Zirconiumnitrid, Hafniumnitrid, Tantalnitrid, Niobnitrid, und
(c) eine Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Chrom, Titan und Nitriden und Oxynitriden von Silicium-Metall-Legierungen.

2. Heiß bearbeitbarer metallisch aussehender beschichteter Gegenstand, aufweisend:
(a) ein transparentes Glassubstrat,
(b) einen Film aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid, und
(c) eine Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Titan und Nitriden und Oxynitriden von Silicium-Metall-Legierungen.

3. Beschichteter Gegenstand nach Anspruch 1, bei dem der Film aus der Metallverbindung Chromnitrid ist.

4. Beschichteter Gegenstand nach Anspruch 2, bei dem der Film aus der Metallverbindung ausgewählt ist aus der Gruppe bestehend aus Chromnitrid und Titannitrid.

5. Beschichteter Gegenstand nach Anspruch 1, wobei die Schutzschicht ausgewählt ist aus der Gruppe bestehend aus Chrom und Titan.

6. Beschichteter Gegenstand nach Anspruch 2, wobei die Schutzschicht Titan ist.

7. Beschichteter Gegenstand nach Anspruch 1 oder 2, wobei der Film aus der Metallverbindung Chromnitrid ist und die Schutzschicht Titan ist.

8. Beschichteter Gegenstand nach einem der Ansprüche 1-7, wobei eine amorphe Metalloxidschicht zwischen dem Film aus der Metallverbindung und der Schutzschicht abgeschieden ist.

9. Beschichteter Gegenstand nach Anspruch 8, wobei diese amorphe Metalloxidschicht Zink und Zinn enthält.

10. Beschichteter Gegenstand nach Anspruch 9, wobei der Film aus der Metallverbindung ausgewählt ist aus der Gruppe bestehend aus Chromnitrid und Titannitrid, die Schutzschicht Titan ist und die amorphe Metalloxidschicht die angenäherte Zusammensetzung Zn₂SnO₄ aufweist.

11. Beschichteter Gegenstand nach Anspruch 1 oder 2, wobei eine stabilisierende Schicht, ausgewählt aus der Gruppe bestehend aus Silicium, Titan, Zirconium, Tantal, Chrom, Niob, Siliciumlegierungen, Nickel-Chrom-Legierungen und Aluminiumnitrid, zwischen diesem Glassubstrat und diesem Film aus der Metallverbindung abgeschieden ist.

12. Beschichteter Gegenstand nach Anspruch 11, wobei die Schutzschicht ausgewählt ist aus der Gruppe bestehend aus Nitriden und Oxynitriden von Silicium und Silicium-Metall-Legierungen.

13. Beschichteter Gegenstand nach Anspruch 11 oder 12, wobei der Film aus der Metallverbindung ausgewählt aus der Gruppe bestehend aus Chromnitrid, Titannitrid, Titanborid, Titancarbid, Zirconiumnitrid, Hafniumnitrid, Tantalnitrid, Niobnitrid, Titanoxynitrid, Zirconiumoxynitrid, Chromoxynitrid, Tantaloxynitrid und Nioboxynitrid.

14. Beschichteter Gegenstand nach Anspruch 12, wobei die Schutzschicht ausgewählt ist aus der Gruppe bestehend aus Siliciumnitrid, Siliciumoxynitrid, Silicium-Nickel-Nitrid, Silicium-Nickel-Oxynitrid, Silicium-Aluminium-Nitrid, Silicium-Aluminium-Oxynitrid, Silicium-Eisen-Nitrid, Silicium-Eisen-Oxynitrid, Silicium-Chrom-Nitrid, Silicium-Chrom-Oxynitrid, Silicium-Nickel-Chrom-Nitrid, Silicium-Nickel-Chrom-Oxynitrid, Silicium-Bor-Nitrid und Silicium-Bor-Oxynitrid.

15. Beschichteter Gegenstand nach Anspruch 11, wobei die stabilisierende Schicht ein Metall enthält, das ausgewählt ist aus der Gruppe bestehend aus Silicium und Titan, der Film aus der Metallverbindung Titannitrid enthält und die Schutzschicht Siliciumnitrid oder -oxynitrid enthält.

16. Beschichteter Gegenstand nach Anspruch 11, wobei die stabilisierende Schicht eine Silicium-Metall-Legierung oder Titan ist, der Film aus der Metallverbindung Titannitrid ist und die Schutzschicht ausgewählt ist aus der Gruppe bestehend aus Nitriden von Silicium-Metall-Legierungen und Oxynitriden von Silicium-Metall-Legierungen.

17. Beschichteter Gegenstand nach einem der Ansprüche 12-16, wobei eine zusätzliche Schicht zwischen dem Film aus der Metallverbindung und der Schutzschicht abgeschieden ist.

18. Beschichteter Gegenstand nach Anspruch 17, wobei diese zusätzliche Schicht ausgewählt ist aus der Gruppe bestehend aus Silicium, Titan, Silicium-Metall-Legierungen und Oxiden, Nitriden und Oxynitriden davon.

19. Beschichteter Gegenstand nach Anspruch 17, wobei die stabilisierende Schicht Silicium oder Titan enthält, der Film aus der Metallverbindung Titannitrid ist, die zusätzliche Schicht ausgewählt ist aus der Gruppe bestehend aus Silicium, Titan, Silicium-Metall-Legierungen und Aluminiumnitrid und die Schutzschicht ausgewählt ist aus der Gruppe bestehend aus Siliciumnitrid, Siliciumoxynitrid, Silicium-Nickel-Nitrid, Silicium-Nickel-Oxynitrid, Silicium-Aluminium-Nitrid, Silicium-Aluminium-Oxynitrid, Silicium-Eisen-Nitrid, Silicium-Eisen-Oxynitrid, Silicium-Chrom-Nitrid, Silicium-Chrom-Oxynitrid, Silicium-Nickel-Chrom-Nitrid, Silicium-Nickel-Chrom-Oxynitrid, Silicium-Bor-Nitrid und Silicium-Bor-Oxynitrid.

20. Verfahren zur Herstellung eines heiß bearbeiteten metallisch aussehenden Gegenstands, umfassend die Schritte:
(a) Abscheiden eines Films aus einer Metallverbindung mit metallischen Eigenschaften, ausgewählt aus der Gruppe bestehend aus Metallboriden, Metallcarbiden, Metalloxynitriden, Chromnitrid, Titannitrid, Zirconiumnitrid, Hafniumnitrid, Tantalnitrid, Niobnitrid, auf einer Oberfläche eines Glassubstrats und
(b) Abscheiden einer Schutzschicht, die ein zu dem Metall der Metallverbindung des Films unterschiedliches Metall enthält und die Oxidation des Films aus der Metallverbindung minimiert und ausgewählt ist aus der Gruppe bestehend aus Chrom, Titan und Nitriden und Oxynitriden von Silicium und Silicium-Metall-Legierungen, und
(c) Erhitzen des Glassubstrats, auf dem dieser Film aus der Metallverbindung und diese Schutzschicht abgeschieden sind, auf eine Temperatur, die ausreicht, um das Glas zu biegen.

21. Verfahren nach Anspruch 20, das zusätzlich den Schritt des Abscheidens eines amorphen Metalloxids zwischen diesem Film aus der Metallverbindung und dieser Schutzschicht umfasst.

22. Verfahren nach Anspruch 20, das zusätzlich den Schritt des Abscheidens einer stabilisierenden Schicht, ausgewählt aus der Gruppe bestehend aus Silicium, Titan, Zirconium, Tantal, Chrom, Niob, Siliciumlegierungen, Nickel-Chrom-Legierungen und Aluminiumnitrid, zwischen diesem Glassubstrat und diesem Film aus der Metallverbindung umfasst.

23. Verfahren nach Anspruch 22, das zusätzlich den Schritt des Abscheidens einer zusätzlichen Schicht zwischen dem Film aus der Metallverbindung und der Schutzschicht umfasst.

24. Verfahren nach Anspruch 23, wobei diese zusätzlichen Schicht ausgewählt ist aus der Gruppe bestehend aus Silicium, Titan, einer Silicium-Metall-Legierung, Nitriden, Oxiden und Oxynitriden davon.

## Revendications (Revendications pour l'(les) Etat(s) contractant(s) suivant(s): DE, FR, GB, IT)

1. Article revêtu d'aspect métallique, traitable à chaud comprenant :
(a) un substrat de verre transparent;
(b) un film de composé métallique avec des propriétés métalliques choisi dans le groupe comprenant les borures métalliques, les carbures métalliques, les oxynitrures métalliques, le nitrure de chrome, le nitrure de zirconium, le nitrure d'hafnium, le nitrure de tantale, le nitrure de niobium; et
(c) une couche protectrice comprenant un métal différent du film de composé métallique qui minimise l'oxydation du film de composé métallique et est choisi dans le groupe comprenant le chrome, le titane et les nitrures et oxynitrures d'alliages de silicium-métal à l'exception du nitrure de silicium-zirconium et du nitrure de silicium-étain.

2. Article revêtu d'aspect métallique, traitable à chaud comprenant :
(a) un substrat de verre transparent;
(b) un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(c) une couche protectrice comprenant un métal différent du film de composé métallique qui minimise l'oxydation du film de composé métallique et est choisi dans le groupe comprenant le titane et les nitrures et oxynitrures d'alliages de silicium-métal à l'exception du nitrure de silicium-zirconium et du nitrure de silicium-étain.

3. Article revêtu suivant la revendication 1, dans lequel le film de composé métallique est du nitrure de chrome.

4. Article revêtu suivant la revendication 2, dans lequel le film de composé métallique est choisi dans le groupe comprenant le nitrure de chrome et le nitrure de titane.

5. Article revêtu suivant la revendication 1, dans lequel la couche protectrice est choisie dans le groupe comprenant le chrome et le titane.

6. Article revêtu suivant la revendication 2, dans lequel la couche protectrice est du titane.

7. Article revêtu suivant l'une ou l'autre des revendications 1 et 2, dans lequel le film de composé métallique est du nitrure de chrome et la couche protectrice est du titane.

8. Article revêtu suivant l'une quelconque des revendications 1 à 7, dans lequel une couche d'oxyde métallique amorphe est déposée entre le film de composé métallique et la couche protectrice.

9. Article revêtu suivant la revendication 8, dans lequel ladite couche d'oxyde métallique amorphe comprend du zinc et de l'étain.

10. Article revêtu suivant la revendication 9, dans lequel le film de composé métallique est choisi dans le groupe comprenant le nitrure de chrome et le nitrure de titane, la couche protectrice est du titane, et la couche d'oxyde métallique amorphe a la composition approximative Zn₂SnO₄.

11. Article revêtu d'aspect métallique, traitable à chaud comprenant :
(a) un substrat de verre transparent;
(b) un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(c) une couche protectrice comprenant un métal différent du film de composé métallique qui minimise l'oxydation du film de composé métallique et est choisi dans le groupe comprenant le chrome, le titane et les nitrures et oxynitrures de silicium et d'alliages de silicium-métal;
dans lequel une couche de stabilisation choisie dans le groupe comprenant le silicium, le titane, le zirconium, le tantale, le chrome, le niobium, les alliages de silicium, les alliages de nickel-chrome et le nitrure d'aluminium est déposée entre le substrat de verre précité et le film de composé métallique précité.

12. Article revêtu suivant la revendication 11, dans lequel la couche protectrice est choisie dans le groupe comprenant les nitrures et oxynitrures de silicium et d'alliages de silicium-métal.

13. Article revêtu suivant l'une ou l'autre des revendications 11 et 12, dans lequel le film de composé métallique est choisi dans le groupe comprenant le nitrure de chrome, le nitrure de titane, le borure de titane, le carbure de titane, le nitrure de zirconium, le nitrure d'hafnium, le nitrure de tantale, le nitrure de niobium, l'oxynitrure de titane, l'oxynitrure de zirconium, l'oxynitrure de chrome, l'oxynitrure de tantale et l'oxynitrure de niobium

14. Article revêtu suivant la revendication 12, dans lequel la couche protectrice est choisie dans le groupe comprenant le nitrure de silicium, l'oxynitrure de silicium, le nitrure de silicium-nickel, l'oxynitrure de silicium-nickel, le nitrure de silicium-aluminium, l'oxynitrure de silicium-aluminium, le nitrure de silicium-fer, l'oxynitrure de silicium-fer, le nitrure de silicium-chrome, l'oxynitrure de silicium-chrome, le nitrure de silicium-nickel-chrome, l'oxynitrure de silicium-nickel-chrome, le nitrure de silicium-bore et l'oxynitrure de silicium-bore.

15. Article revêtu suivant la revendication 11, dans lequel la couche de stabilisation contient un métal choisi dans le groupe comprenant le silicium et le titane, le film de composé métallique comprend du nitrure de titane et la couche protectrice comprend du nitrure ou de l'oxynitrure de silicium.

16. Article revêtu suivant la revendication 11, dans lequel la couche de stabilisation est un alliage de silicium-métal ou du titane, le film de composé métallique est du nitrure de titane et la couche protectrice est choisie dans le groupe comprenant un nitrure d'alliage de silicium-métal et un oxynitrure d'alliage de silicium-métal.

17. Article revêtu suivant l'une quelconque des revendications 12 à 16, dans lequel une couche additionnelle est déposée entre le film de composé métallique et la couche protectrice.

18. Article revêtu suivant la revendication 17, dans lequel la couche additionnelle précitée est choisie dans le groupe comprenant le silicium, le titane, les alliages de silicium-métal et leurs oxydes, nitrures et oxynitrures.

19. Article revêtu suivant la revendication 17, dans lequel la couche de stabilisation comprend du silicium ou du titane, le film de composé métallique est du nitrure de titane, la couche additionnelle est choisie dans le groupe comprenant le silicium, le titane, les alliages de silicium-métal et le nitrure d'aluminium, et la couche protectrice est choisie dans le groupe comprenant le nitrure de silicium, l'oxynitrure de silicium, le nitrure de silicium-nickel, l'oxynitrure de silicium-nickel, le nitrure de silicium-aluminium, l'oxynitrure de silicium-aluminium, le nitrure de silicium-fer, l'oxynitrure de silicium-fer, le nitrure de silicium-chrome, l'oxynitrure de silicium-chrome, le nitrure de silicium-nickel-chrome, l'oxynitrure de silicium-nickel-chrome, le nitrure de silicium-bore et l'oxynitrure de silicium-bore.

20. Procédé de fabrication d'un article d'aspect métallique traité à chaud comprenant les étapes de :
(a) dépôt sur une surface d'un substrat de verre d'un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(b) dépôt d'une couche protectrice comprenant un métal différent du film de composé métallique qui minimise l'oxydation du film de composé métallique et est choisi dans le groupe comprenant le chrome, le titane et les nitrures et oxynitrures d'alliages de silicium-métal à l'exception du nitrure de silicium-zirconium et du nitrure de silicium-étain; et
(c) chauffage du substrat de verre sur lequel sont déposés le film de composé métallique et la couche protectrice précités à une température suffisante pour courber le verre.

21. Procédé suivant la revendication 20, comprenant de plus l'étape de dépôt d'un oxyde métallique amorphe entre ledit film de composé métallique et ladite couche protectrice.

22. Procédé de fabrication d'un article d'aspect métallique traité à chaud comprenant les étapes de :
(a) dépôt sur une surface d'un substrat de verre d'un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(b) dépôt d'une couche protectrice comprenant un métal différent du film de composé métallique qui minimise l'oxydation du film de composé métallique et est choisi dans le groupe comprenant le chrome, le titane et les nitrures et oxynitrures de silicium et d'alliages de silicium-métal; et
(c) chauffage du substrat de verre sur lequel sont déposés le film de composé métallique et la couche protectrice précités à une température suffisante pour courber le verre,
comprenant de plus l'étape de dépôt d'une couche de stabilisation choisie dans le groupe comprenant le silicium, le titane, le zirconium, le tantale, le chrome, le niobium, les alliages de silicium, les alliages de nickel-chrome et le nitrure d'aluminium, entre ledit substrat de verre et ledit film de composé métallique.

23. Procédé suivant la revendication 22, comprenant de plus l'étape de dépôt d'une couche additionnelle entre le film de composé métallique et la couche protectrice.

24. Procédé suivant la revendication 23, dans lequel ladite couche additionnelle est choisie dans le groupe comprenant le silicium, le titane, un alliage de silicium-métal, leurs nitrures, oxydes et oxynitrures.

25. Article revêtu d'aspect métallique, traitable à chaud comprenant :
(a) un substrat de verre transparent,
(b) un film de composé métallique avec des propriétés métalliques qui est du nitrure de titane,
(c) une couche protectrice qui est du nitrure de silicium.

## Revendications (Revendications pour l'(les) Etat(s) contractant(s) suivant(s): CH, ES, LI, LU, SE)

1. Article revêtu d'aspect métallique, traitable à chaud comprenant :
(a) un substrat de verre transparent;
(b) un film de composé métallique avec des propriétés métalliques choisi dans le groupe comprenant les borures métalliques, les carbures métalliques, les oxynitrures métalliques, le nitrure de chrome, le nitrure de zirconium, le nitrure d'hafnium, le nitrure de tantale, le nitrure de niobium; et
(c) une couche protectrice comprenant un métal différent du film de composé métallique qui minimise l'oxydation du film de composé métallique et est choisi dans le groupe comprenant le chrome, le titane et les nitrures et oxynitrures de silicium et d'alliages de silicium-métal.

2. Article revêtu d'aspect métallique, traitable à chaud comprenant :
(a) un substrat de verre transparent;
(b) un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(c) une couche protectrice comprenant un métal différent du film de composé métallique qui minimise l'oxydation du film de composé métallique et est choisi dans le groupe comprenant le titane et les nitrures et oxynitrures de silicium et d'alliages de silicium-métal.

3. Article revêtu suivant la revendication 1, dans lequel le film de composé métallique est du nitrure de chrome.

4. Article revêtu suivant la revendication 2, dans lequel le film de composé métallique est choisi dans le groupe comprenant le nitrure de chrome et le nitrure de titane.

5. Article revêtu suivant la revendication 1, dans lequel la couche protectrice est choisie dans le groupe comprenant le chrome et le titane.

6. Article revêtu suivant la revendication 2, dans lequel la couche protectrice est du titane.

7. Article revêtu suivant l'une ou l'autre des revendications 1 et 2, dans lequel le film de composé métallique est du nitrure de chrome et la couche protectrice est du titane.

8. Article revêtu suivant l'une quelconque des revendications 1 à 7, dans lequel une couche d'oxyde métallique amorphe est déposée entre le film de composé métallique et la couche protectrice.

9. Article revêtu suivant la revendication 8, dans lequel ladite couche d'oxyde métallique amorphe comprend du zinc et de l'étain.

10. Article revêtu suivant la revendication 9, dans lequel le film de composé métallique est choisi dans le groupe comprenant le nitrure de chrome et le nitrure de titane, la couche protectrice est du titane, et la couche d'oxyde métallique amorphe a la composition approximative Zn₂SnO₄.

11. Article revêtu suivant l'une ou l'autre des revendications 1 et 2, dans lequel une couche de stabilisation choisie dans le groupe comprenant le silicium, le titane, le zirconium, le tantale, le chrome, le niobium, les alliages de silicium, les alliages de nickel-chrome et le nitrure d'aluminium, est déposée entre le substrat de verre précité et le film de composé métallique précité.

12. Article revêtu suivant la revendication 11, dans lequel la couche protectrice est choisie dans le groupe comprenant les nitrures et oxynitrures de silicium et d'alliages de silicium-métal.

13. Article revêtu suivant l'une ou l'autre des revendications 11 et 12, dans lequel le film de composé métallique est choisi dans le groupe comprenant le nitrure de chrome, le nitrure de titane, le borure de titane, le carbure de titane, le nitrure de zirconium, le nitrure d'hafnium, le nitrure de tantale, le nitrure de niobium, l'oxynitrure de titane, l'oxynitrure de zirconium, l'oxynitrure de chrome, l'oxynitrure de tantale et l'oxynitrure de niobium

14. Article revêtu suivant la revendication 12, dans lequel la couche protectrice est choisie dans le groupe comprenant le nitrure de silicium, l'oxynitrure de silicium, le nitrure de silicium-nickel, l'oxynitrure de silicium-nickel, le nitrure de silicium-aluminium, l'oxynitrure de silicium-aluminium, le nitrure de silicium-fer, l'oxynitrure de silicium-fer, le nitrure de silicium-chrome, l'oxynitrure de silicium-chrome, le nitrure de silicium-nickel-chrome, l'oxynitrure de silicium-nickel-chrome, le nitrure de silicium-bore et l'oxynitrure de silicium-bore.

15. Article revêtu suivant la revendication 11, dans lequel la couche de stabilisation contient un métal choisi dans le groupe comprenant le silicium et le titane, le film de composé métallique comprend du nitrure de titane et la couche protectrice comprend du nitrure ou de l'oxynitrure de silicium.

16. Article revêtu suivant la revendication 11, dans lequel la couche de stabilisation est un alliage de silicium-métal ou du titane, le film de composé métallique est du nitrure de titane et la couche protectrice est choisie dans le groupe comprenant un nitrure d'alliage de silicium-métal et un oxynitrure d'alliage de silicium-métal.

17. Article revêtu suivant l'une quelconque des revendications 12 à 16, dans lequel une couche additionnelle est déposée entre le film de composé métallique et la couche protectrice.

18. Article revêtu suivant la revendication 17, dans lequel la couche additionnelle précitée est choisie dans le groupe comprenant le silicium, le titane, les alliages de silicium-métal et leurs oxydes, nitrures et oxynitrures.

19. Article revêtu suivant la revendication 17, dans lequel la couche de stabilisation comprend du silicium ou du titane, le film de composé métallique est du nitrure de titane, la couche additionnelle est choisie dans le groupe comprenant le silicium, le titane, les alliages de silicium-métal et le nitrure d'aluminium, et la couche protectrice est choisie dans le groupe comprenant le nitrure de silicium, l'oxynitrure de silicium, le nitrure de silicium-nickel, l'oxynitrure de silicium-nickel, le nitrure de silicium-aluminium, l'oxynitrure de silicium-aluminium, le nitrure de silicium-fer, l'oxynitrure de silicium-fer, le nitrure de silicium-chrome, l'oxynitrure de silicium-chrome, le nitrure de silicium-nickel-chrome, l'oxynitrure de silicium-nickel-chrome, le nitrure de silicium-bore et l'oxynitrure de silicium-bore.

20. Procédé de fabrication d'un article d'aspect métallique traité à chaud comprenant les étapes de :
(a) dépôt sur une surface d'un substrat de verre d'un film de composé métallique avec des propriétés métalliques choisi dans le groupe comprenant les borures métalliques, les carbures métalliques, les oxynitrures métalliques, le nitrure de chrome, le nitrure de titane, le nitrure de zirconium, le nitrure d'hafnium, le nitrure de tantale, le nitrure de niobium; et
(b) dépôt d'une couche protectrice comprenant un métal différent du film de composé métallique qui minimise l'oxydation du film de composé métallique et est choisi dans le groupe comprenant le chrome, le titane et les nitrures et oxynitrures de silicium et d'alliages de silicium-métal; et
(c) chauffage du substrat de verre sur lequel sont déposés le film de composé métallique et la couche protectrice précités à une température suffisante pour courber le verre.

21. Procédé suivant la revendication 20, comprenant de plus l'étape de dépôt d'un oxyde métallique amorphe entre ledit film de composé métallique et ladite couche protectrice.

22. Procédé suivant la revendication 20, comprenant comprenant de plus l'étape de dépôt d'une couche de stabilisation choisie dans le groupe comprenant le silicium, le titane, le zirconium, le tantale, le chrome, le niobium, les alliages de silicium, les alliages de nickel-chrome et le nitrure d'aluminium, entre ledit substrat de verre et ledit film de composé métallique.

23. Procédé suivant la revendication 22, comprenant de plus l'étape de dépôt d'une couche additionnelle entre le film de composé métallique et la couche protectrice.

24. Procédé suivant la revendication 23, dans lequel ladite couche additionnelle est choisie dans le groupe comprenant le silicium, le titane, un alliage de silicium-métal, leurs nitrures, oxydes et oxynitrures.
